# EUROPEAN PATENT SPECIFICATION

(11) **EP 2 615 897 B1**
(45) Date of publication and mention of the grant of the patent: **18.03.2015**
(21) Application number: 12151320.4
(22) Date of filing: 16.01.2012
(51) Int. Cl.: H05K 7/20

(54) **Modular raised floor for use in a raised-floor controlled-fluid-flow system, flooring module, and method of use of modular raised floor**
Modularer Zwischenboden zur Verwendung in einem geregelten Durchflusssystem für Zwischenböden, Fußbodenmodul und Verfahren zur Verwendung des modularen Zwischenbodens
Plancher surélevé modulaire pour une utilisation dans un système de débit contrôlé de fluides de plancher surélevé, module de revêtement de plancher et procédé d'utilisation de plancher surélevé modulaire

(43) Date of publication of application: 17.07.2013
(73) Proprietor: Fujitsu Limited, Kawasaki-shi, Kanagawa 211-8588 (JP)
(72) Inventor: Albornoz, Jose, Hayes, Middlesex UB4 8FE (GB); van den Berghe, Sven, Marlow, Buckinghamshire SL7 3LE (GB); Chow, Peter, Gillingham, Kent ME7 3AH (GB)
(74) Representative: Hutchison, James

(56) References cited:
- US-A1- 2004 109 288
- US-A1- 2005 159 099
- US-A1- 2009 301 693
- US-A1- 2009 305 625

## Description

This invention lies in the field of controlled fluid flow systems. In particular, this invention relates to a raised-floor-type controlled fluid flow system of the type that may be used in, for example, data centre cooling.

For many years raised floors have been the technology of choice to deliver cool air to IT equipment in data centres, and raised floors are also used in a variety of other applications in which control of fluid flow into an enclosure is required.

Horizontal and vertical bars are arranged to create a structure at a certain height over the fixed floor of the room or enclosure into which the raised floor is fitted. Floor tiles are placed over the structure. In certain implementations, cables and tubes can be routed to and from equipment and apparatus in the space under the structure. Air conditioning units, such as computer-room air conditioning (CRAC) units, are used to pump cool air into the space below the raised floor, turning this space into a pressurised plenum chamber; the positive pressure within this pressurised plenum drives cool air through perforated tiles, cooling equipment placed within the room or enclosure. However, if the layout of equipment within the room or enclosure changes, placement of the perforated tiles must be changed in order to change the locations to which cool air can be delivered. Cabling, piping, grounding systems, and structural beams are located underneath the raised floor.

Known systems include those in which horizontal and vertical panels are used to create air passages conducting conditioned air from CRAC units to perforated tiles; these panels are also used to create separate passages for cabling and tubing. However, if the layout or activity of equipment within the room or enclosure changes, the position of the perforated tiles may need to be changed in response, and the arrangement of the underfloor panels configuring air passages must also be changed. Such rearrangement of tiles and panels is time-consuming since it involves the disassembly and reassembly of the raised floor structure, and often requires some downtime of operational equipment within the room or enclosure.

US 2009301693 (A1) discloses ventilation systems and methods, and more particularly selectively configurable climate control systems and methods for use in data centres and the like. A device includes a support element and a plurality of ducts connected to the support element, and a manifold in fluid communication with each one of the plurality of ducts and a plurality of valves. Each respective one of the plurality of valves is associated with a respective one of the plurality of ducts. Moreover, there is at least one actuator operatively connected to the plurality of valves, which is structured and arranged to individually actuate each one of the plurality of valves.

US 2005159099 (A1) discloses an airflow distribution control system for usage in a raised-floor data centre, which comprises an under-floor partition with a controllable flow resistance and a sensor. The partition is capable of selective positioning in a plenum beneath the raised-floor. The sensor is communicatively coupled to the partition and detects a parameter indicative of airflow distribution and controls the flow resistance based on the parameter.

US 2004109288 (A1) discloses, in a data centre, a plurality of racks are cooled by activating a cooling device and opening a controllable partition configured to vary a supply of cooling fluid within a zone of the data centre. The zone includes at least one associated rack of the plurality of racks. In addition, the temperature of at least one associated rack is sensed and it is determined whether the sensed temperature is within a predetermined temperature range. Furthermore, the controllable partition is manipulated to vary the supply of the cooling fluid to the zone in response to the sensed temperature being outside the predetermined temperature range.

US 2009305625 (A1) discloses ventilation systems and methods, and more particularly selectively configurable climate control systems and methods for use in data centres and the like. A system includes a first structural element and a second structural element spaced apart from first structural element to define a space between the first and second structural elements. The system also includes a plurality of partitions moveable into the space between the first and second structural elements and a controller arranged to control movement of the plurality of partitions.

In an aspect embodying the present invention, there is provided a configurable flooring module for use in a raised-floor controlled-fluid-flow system, the flooring module comprising: a raised floor support surface and an elevation structure configured to hold the raised floor support surface in an elevated position; a first wall of the elevation structure having a first wall aperture, and a second wall of the elevation structure having a second wall aperture; the first wall providing a side of a plenum and the second wall providing another side of a plenum, which plenum, when in use, provides a fluid connection between the first wall aperture and the second wall aperture. The configurable flooring module further provides an actuator, a shutter, and a remote signal receiver; wherein at least the first wall aperture is configured to be opened and closed by the actuator moving the shutter in response to a remote signal received by the remote signal receiving means.

Advantageously, a configurable flooring module such as that described above enables fluid to have its path changed in response to changes in the layout of equipment or operating conditions in either the enclosure or the controlled-fluid flow system itself. For example, it could be that equipment is switched to an 'off' or low power state, in which case cooled air does not need to be targeted at that equipment. An aperture allowing the passage of cooled air (as an example of a fluid) towards that equipment could be blocked by sending a remote signal to the remote signal receiver, thus allowing the cooled air to be channelled elsewhere.

Advantages of embodiments of the present invention can be illustrated by considering an example of an IT data centre enclosure having a raised-floor controlled-fluid-flow system. Data centres are examples of dynamic environments where servers are installed and/or removed on an almost daily basis; consequently, the location of the sources of heat within the data centre will also change. This is particularly evident in collocation data centres and in virtualised environments as virtual machines are migrated or restarted in different servers. In order to cool equipment such as IT equipment efficiently, it is desirable to direct cool air to the vicinity in which it is needed with the minimum possible energy expense. The location of heat sources within the data centre may move as IT loads are moved between servers or other equipment. The only way to direct cooled air in conventional raised-floor controlled-fluid-flow systems is by changing the position of perforated floor tiles (switching them with solid floor tiles): the success of this measure depends on the pressure distribution in the underfloor (which drives airflow through perforated tiles), which in turn depends on the number and position of CRAC units, the geometry of the raised floor, the presence of cabling and other under-floor obstacles, etc. If several CRAC units are operating in a data centre, turning off one or more units to save energy (a situation that might be encountered if loads are moved to one end of the hall) will disrupt the underfloor pressure distribution, consequently affecting the airflow. Additionally, part of the energy employed to deliver cool air to the underfloor may be lost due to leakage through cable openings and cracks between tiles.

The physical effect of configurable flooring modules embodying the present invention is to reduce the energy required to cool equipment by optimising fluid usage in the raised-floor controlled-fluid-flow system. That is to say, the provision of one or more configurable flooring modules embodying the present invention enables the routing of cooled air in a raised floor beneath a data centre to be adapted according to changes in the enclosure being cooled. The ability to block an aperture from allowing fluid through by a remote signal makes it quick and easy to re-route fluid flow. Furthermore, the re-routing of fluid flow can be automated by implementing a control mechanism which is configured to send a signal to the signal receiving means of the configurable flooring module in response to certain events or environmental changes.

By configurable flooring module it is meant that the flooring module has at least one aperture through which fluid can either flow or not depending on whether the aperture is configured to be in an open state (opened) or in a closed state (closed). Optionally, embodiments of the present invention extend to configurable flooring modules which have apertures which are configurable to be in a number of partially open or closed states in addition to simply open or closed. Advantageously, fine control over pressures within different regions of ducting formed by connected plenums is thus achievable.

The nature of a raised-floor controlled-fluid-flow system is that it is raised with respect to a fixed floor of an enclosure (which should be interpreted as broad enough to include 'room') within which it is installed, and in turn provides a raised floor for the enclosure.

The raised floor support surface may be configured to support a single floor tile in a raised position above a fixed floor (supported by the elevation structure). Alternatively, a single configurable flooring module may be configured to support more than one floor tile. As a further alternative, a single floor tile, or perhaps an entire floor, could be supported by more than one configurable flooring module. The configurable flooring module may be provided as a module without a floor tile so that a standard floor tile may be fitted.

The precise form of the elevation structure will depend on the particular implementation. However, the elevation structure should include at least two walls (each having an aperture), which two walls may be provided perpendicular to or facing one another, and perpendicular to a plane in which a floor tile or floor, when fitted, would be disposed. The elevation structure may include several component parts and structural elements, some of which may not necessarily provide physical support to the raised floor support surface, but which are considered part of the elevation structure nonetheless.

The plenum is not constrained to having a positive pressure, and may contain fluid at the same pressure as the enclosure in which the configurable flooring module and raised floor are fitted. However, in certain embodiments and implementations, the plenum may be operated at a positive pressure. A cooling effect can still be achieved if, for example, the temperature of fluid within the plenum is cooler than parts of the enclosure environment close to the floor. The plenum may not be properly defined until a floor or flooring tile has been fitted to the configurable flooring module. Therefore, the plenum is a space partially defined by elements of the configurable flooring module, but is not necessarily a component of the configurable flooring module itself.

The fluid connection formed by the plenum when in use is not necessarily tight to the fluid. That is to say, some fluid may be lost between the apertures, for example, through a perforated floor or flooring tile forming a side of the plenum.

The actuators may be of any construction operable to open and close the shutter, for example electric or hydraulic actuators. The shutter may be in the form of one or more blinds, curtains, diaphragms or any other apparatus appropriate to block (close) an aperture, and to be moved away or rotated in order to open the aperture. It may be that an actuator is configured to open and close shutters of more than one aperture. Alternatively, the actuator of a particular configurable flooring module may comprise more than one actuator unit, each actuator unit configured to open and close the shutter of a particular aperture. Similarly, the remote signal receiver may be a single receiver, or may comprise more than one sensor each configured to sense that a remote signal has been received. For example, there may be two sensors per aperture that can be opened and closed.

A flooring module embodying the present invention can be arranged with a plurality of other flooring modules embodying the present invention to provide a raised floor, or structure onto which a raised floor can be placed.

Optionally, when a raised floor is fitted to the raised floor support surface, the raised floor provides another wall of the plenum. Advantageously, an arrangement in which the raised floor provides a wall of the plenum obviates the need for a separate structural element to provide that wall of the plenum.

Furthermore, the raised floor may be a perforated floor tile fitted to the raised floor support surface as a raised floor. Hence, advantageously, when the floor tile is a wall of the plenum, fluid from the plenum can pass through the perforations into the enclosure in which the configurable flooring module is installed.

Optionally, a configurable flooring module embodying the present invention may further comprise a baseplate providing a side of the plenum opposed to the side provided by the raised floor when the raised floor is fitted.

Optionally, the elevation structure further comprises one or more stands configured to support the raised floor above a fixed floor such that the baseplate is also raised above the fixed floor. Advantageously, stands raising the baseplate above the fixed floor serve to provide a volume between the baseplate and the fixed floor, which volume can be used for cables, pipes, and other apparatus.

Optionally, the baseplate is removable or detachable. Advantageously, a removable basepate enables certain configurable flooring modules in a raised floor including more than one such flooring module, to be used to allow cables, pipes, and other apparatus to be fed between the raised floor and the volume between the baseplate and the fixed floor. Optionally, the baseplate and the raised floor may have openings or orifices fitted with seals, gaskets or grommets in order to allow cables, pipes, and other apparatus to be fed between the raised floor and the volume between the baseplate and the fixed floor while preserving the fluid-tightness of the plenum.

A configurable flooring module embodying the present invention may also comprise a third wall of the elevation structure having a third wall aperture, the third wall providing a side of the plenum; wherein at least the first wall aperture and second wall aperture are each configured to be opened and closed by the actuating means moving the shutting means in response to a remote received by the remote signal receiving means. Advantageously, the more apertures which can be opened and closed by a remote signal, the more control over the routing of fluid around the raised-floor controlled-fluid-flow system can be achieved. Hence more energy can be saved by optimising fluid usage in the system.

In addition, the configurable flooring module may comprise a fourth wall of the elevation structure having a fourth aperture, the fourth wall providing a side of the plenum; wherein at least the first wall aperture, second wall aperture, and third wall aperture are each configured to be opened and closed by the actuating means moving the shutting means in response to a remote signal received by the remote signal receiving means. The four walls having apertures may define a square prism (with two mutually perpendicular facing-pairs of walls joined at the edges).

The or each wall may take a range of forms, as long as they include apertures allowing the passage of air (when not blocked by a shutter). Optionally, the or each wall is in the form of a wall frame surrounding its respective aperture and forms a complete wall when the aperture is closed.

An aperture may be a single opening in the wall. Alternatively, the or each aperture comprises a plurality of sub-apertures, and the aperture is closed when each of its plurality of sub-apertures is closed. Advantageously, providing a series of sub-apertures enables the mechanical strain on an actuator unit required to move a shutter to cover the aperture to be reduced, since an actuator unit can be provided per sub aperture. For example, it could be that the aperture is blocked by a series of rotational shutters, which are rotated by an actuator unit to be coplanar with the aperture to block the aperture, and rotated away to open the aperture.

In another aspect, embodiments of the present invention provide a modular raised floor for use in a raised-floor controlled-fluid-flow system, the modular raised floor comprising a plurality of flooring modules, of which at least one flooring module is a configurable flooring module embodying the present invention, and any remaining flooring modules are non-configurable flooring modules, each non-configurable flooring module comprising: a raised floor support surface and an elevation structure configured to hold the raised floor support surface in a raised position; walls of the elevation structure having apertures and providing sides of a plenum, which plenum, when in use, provides fluid connections between the apertures.

Any arrangement of configurable and non-configurable flooring modules is possible. However, particularly advantageous arrangements in terms of optimising the flexibility are grid-like arrangements of either exclusively configurable flooring modules, preferably each with four configurable apertures, or a tessellation of alternating (along both rows and columns) configurable and non-configurable flooring modules.

Optionally, the configurable aperture of the configurable flooring module is in fluid communication with a fluid source, for example, a cool air vent, external air, an air conditioning unit, or a CRAC unit.

Optionally, a modular raised floor is provided wherein there is more than one configurable flooring module, and the modular raised floor is configurable such that the first aperture of a first configurable flooring module and the first aperture of a second configurable flooring module are in fluid communication with one another and with a source of fluid. In such a configuration, a controller (such as a user or automated control program or procedure) can configure the configurable apertures to re-route the flow of fluid from the fluid source in order that it can be targeted at different locations in the enclosure in which the raised floor is provided.

In an exemplary arrangement the plurality of flooring modules are configured to be arranged in a grid of horizontal rows and columns. A grid arrangement is advantageous in terms of the structural strength of the raised floor, and in terms of the number of degrees of freedom of fluid routes within the raised floor.

Remote signals may be sent via wires or some other signal line from a controller to the actuator unit of the shutter of a configurable aperture in order to change the configuration of that aperture. Changing the configuration may include changing between an open and closed state, and may also include changing to a partially open or partially closed state. A minimum cabling or wiring requirement is that each actuator unit has some connection to a controller. In an exemplary embodiment, the remote signal receiving means of each configurable flooring module comprises, for each aperture that is configured to be opened and closed in response to a remote signal received by the remote signal receiving means, first and second signal receivers respectively connected to first and second signal line sections; wherein, when the plurality of flooring modules are arranged in a grid: the first signal line section is connectable to signal line sections of adjacent flooring modules to form a signal line running along a grid row; and the second signal line section is connectable to signal line sections of adjacent flooring modules to form a signal line running along a grid column. Advantageously, such a signal line arrangement enables for easy formation of a grid of configurable flooring modules, and for simple addressing of particular actuator units within the grid.

Another aspect of embodiments of the present invention is a method of use of a modular raised floor embodying the present invention, the method comprising: conducting a heat flow simulation of a model of a room in which the raised floor is installed; determining, based on the heat flow simulation, from among the apertures that are configured to be opened and closed, a desired configuration of apertures that should be opened and apertures that should be closed; and sending remote signals to the remote signal receiving means of the configurable flooring modules to realise the desired configuration. The method could be performed by an automated control program.
Figure 1 is a diagrammatic representation of the general structure of a configurable flooring module embodying the present invention;
Figure 2 is a cut-away view diagrammatic representation of a configurable flooring module embodying the present invention;
Figure 3 is a diagrammatic representation of air flowing between two immediately adjacent configurable flooring modules embodying the present invention;
Figure 4 is a diagrammatic representation of the general structure of another example of a configurable flooring module embodying the present invention;
Figure 5 is a diagrammatic representation of a raised floor including configurable flooring modules embodying the present invention and non-configurable flooring modules;
Figure 6 is a diagrammatic representation of a wiring layout of a configurable flooring module embodying the present invention;
Figure 7 is a cut-away view diagrammatic representation of another example of a configurable flooring module embodying the present invention;
Figure 8 is a diagrammatic representation of a wiring layout of a number of configurable flooring modules embodying the present invention arranged in a grid;
Figure 9a is a utilisation example of a raised floor embodying the present invention;
Figure 9b is an example of the effect of reconfiguring the configurable flooring modules in the example of Figure 9a;
Figure 10 illustrates the flow of control in a method of using a raised floor embodying the present invention.

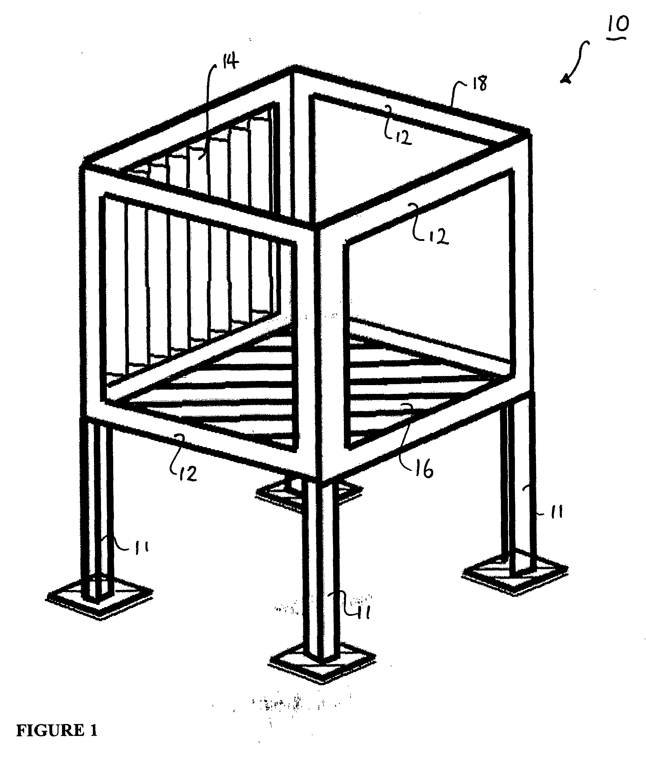

Figure 1 illustrates the general structure of a configurable flooring module. A series of stands 11 hold the walls 12 and baseplate 16 away from a surface on which the stands are based. In an exemplary embodiment, there are a series of four stands, arranged so that they each extend away from the walls 12 and baseplate 16 in the same direction, which direction may be, for example, normal to the plane of the baseplate. The four stands may be arranged with one extending away from each corner of the baseplate 16, or from each corner of a frame or lip into which the baseplate fits. In the exemplary embodiment, there are four walls, each comprising a wall frame surrounding an aperture. Each of the four walls is joined to two other walls by an edge, the joined edges all being parallel to one another, and arranged such that adjacent walls are perpendicular to one another.

In the illustrated example of Figure 1, four apertures are illustrated, but only a single shutter 14. A useful embodiment of the present invention should have at least two walls with apertures, at least one of which provided with a shutter operable to be configured between an open state and a closed state in response to remote signals (hereinafter referred to as a configurable aperture or configurable shutter for convenience). However, in the exemplary embodiment of Figure 1, the shutters of the remaining three walls have been left out of the illustration purely for illustrative purposes, and any permutation or combination of one or more of the apertures could be provided with a configurable shutter. Optimum flexibility in routing fluid is achieved by providing all four walls with a configurable shutter.

In Figure 1, the raised floor support surface 18 is provided by the edges of the walls distal from the stands. This is one example of a raised floor support surface in embodiments of the present invention. Alternatively, a lip could be provided extending around the inside (or along the outside) of the complete edge formed by the edges of the walls distal from the stands. The lip could be proud of or coplanar with the plane of the complete edge so that a floor or floor tile sits on top of the lip, or it could be sunken with respect to the complete edge so that the floor tile is partially or wholly received by the complete edge.

The raised floor support surface may be dimensioned so that it is able to receive standard 2'×2' raised floor tiles on its top.

The stands 11, walls 12, baseplate 16, and raised floor support surface 18 can be considered to be components of an elevation structure, which structure is configured to have sufficient rigidity to withstand the weight of the equipment that is placed on a raised floor fitted to the flooring module 10, and possibly additional weight, such as that of an operative walking across the raised floor.

The height (distance between the raised floor when fitted to the flooring module 10 and base of the stands 11 in a direction normal to the plane of the raised floor) of the configurable flooring module 10 will depend on the particular implementation requirements of the environment in which the invention embodiment is used or installed. The flooring module may be dimensioned such that the height complies with published raised floor recommendations or other design requirements.

It can be seen from Figure 1 that when a baseplate 16 is in position, and a floor or floor tile is fitted to the raised floor support surface, that a plenum is formed by the four walls, the baseplate, and the floor tile. The plenum has one or more configurable apertures so that the destination of fluid flowing into the plenum is configurable. Furthermore, the plenum so formed is held away from a surface by one or more stands, thus there is defined a volume of space between the plenum and said surface (which surface may be, for example, a fixed floor).

In an exemplary embodiment of the present invention the baseplate 16 is removable or detachable. For example, it may be that the baseplate is held in place by screws, bolts, clips, or merely by gravity onto a frame or lip below. Removing the baseplate enables a configurable flooring module to serve as a conduit for running cables, pipes, or other equipment from on top of the raised floor to the volume of space defined between the base plate and the surface on which the raised floor stands. Alternatively, the baseplate may be fitted with seals, gaskets or grommets in order to allow cables, pipes, and other apparatus to be fed between the raised floor and the volume between the baseplate and the fixed floor while preserving the fluid-tightness of the plenum.

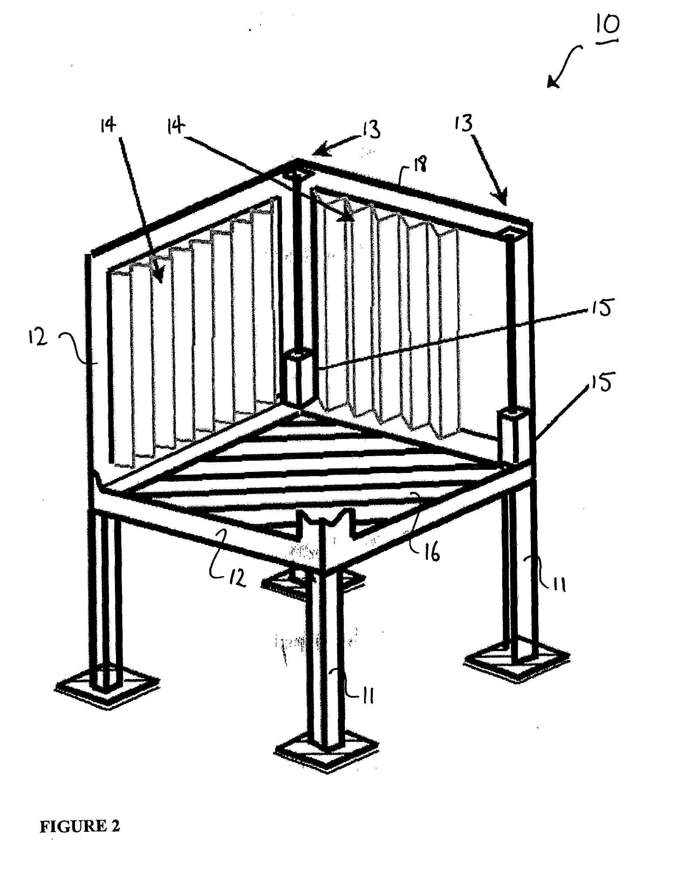

Figure 2 illustrates an exemplary embodiment of the present invention with two walls in the foreground cut-away to enable details such as the actuator units 15 and pins 13 to be seen. The actuator of the illustrated embodiment comprises two actuating units 15, and, depending on the implementation, could also include additional actuating units at the other corners. The actuator units 15 are positioned at the corners where two walls adjoin the baseplate 16 (or lip onto which the baseplate is fitted). The actuator units 15 do not project beyond the frames of the walls 12 so that they do not inhibit fluid flow. In the exemplary embodiment, there is a one to one correspondence between actuator units 15 and shutters 14, although other correspondences are possible. For example, it may be that two actuating units are provided per shutter so that they can work cooperatively to open and close the shutter, and/or to provide redundancy in the case of failure of a particular actuator unit. Similarly, the example shows a one to one correspondence between apertures and shutters 14. Of course, it is possible that an aperture could be subdivided into a number of subapertures, each with their own shutter, and each subaperture having its own actuator unit, or the subapertures all sharing a common actuator unit.

A pin 13 is provided per actuator unit 15. The pins 13 enable manual opening and closing of the shutter 14 associated with the actuator unit 15 for which the pin 13 is provided. The precise nature of the pin 13 will depend on the nature of the actuating unit 15. For example, it may be that the actuating unit 15 includes a rotational motor. In which case, failure of the motor could be compensated by manual winding of the pin to open and close the shutter 14. Optionally, the pins 13 may extend from wherever the actuator units 15 are located toward the level of the raised floor in order that the pins 13 are accessible to a user.

The actuator units 15 may be, for example, electric or hydraulic actuator units, and are configured to open and close blinds, shutters, curtains, diaphragms or any other appropriate apparatus installed in the configurable flooring module 10 in order to allow or block the flow of air through an aperture (all of which are considered to be included in the definition 'shutter' elsewhere in this document). The opening and closing of a shutter 14 (the configuring of a shutter between an open and closed state) is exemplified by the cutaway view shown in Figure 2. The shutter 14 on the left hand side of the figure is in a closed state so that it is operable to block the passage of fluid the aperture which it covers. On the other hand, the shutter 14 on the right hand side of the figure is in the process of being opened or closed, so that it is between an open state and a closed state. Manual operation of the shutters is also possible by using the pins 13, which term includes levers or any other suitable means to provide a manual back-up mechanism for the actuator units.

Configurable flooring modules 10 embodying the present invention can be used to configure an underfloor duct or partition by placing at least one, or optionally an arrangement such as a regular arrangement of configurable flooring modules 10 on a slab (fixed) floor and opening or closing the shutters appropriately, as shown in the next paragraphs and drawings. Hence, routing and re-routing of fluid beneath a raised floor is achievable.

A flooring module embodying the present invention can be built of any material able to provide the necessary structural strength to withstand the weight of the equipment that will be placed over it; depending on the required load the module can be built of aluminium, steel, fibre-reinforned polymer or any other suitable material. The constituent parts of the module can be fastened together using screws, rivets, bolts, welding or other mechanical assembly techniques. Since adjacent modules are mechanically connected (for instance, by using rivets or bolts) to form a raised floor support structure, the structural strength of the resulting structure is greater than that of the beam arrangements that support conventional raised floors. At the same time, the use of flooring modules embodying the invention hinders unauthorized access through the underfloor space, as well as the concealment of people and devices.

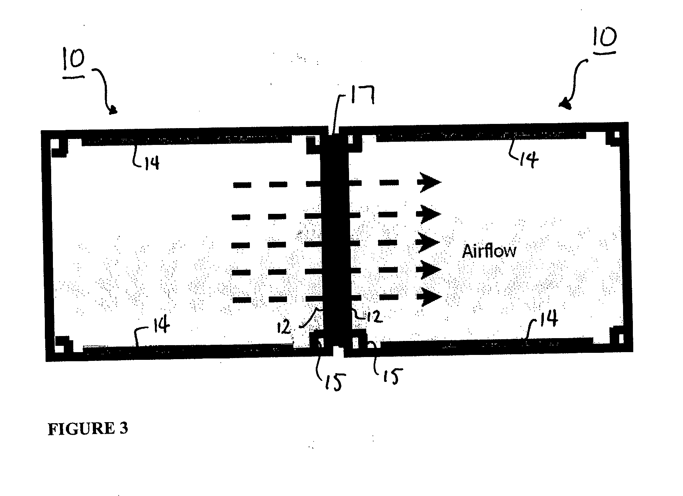

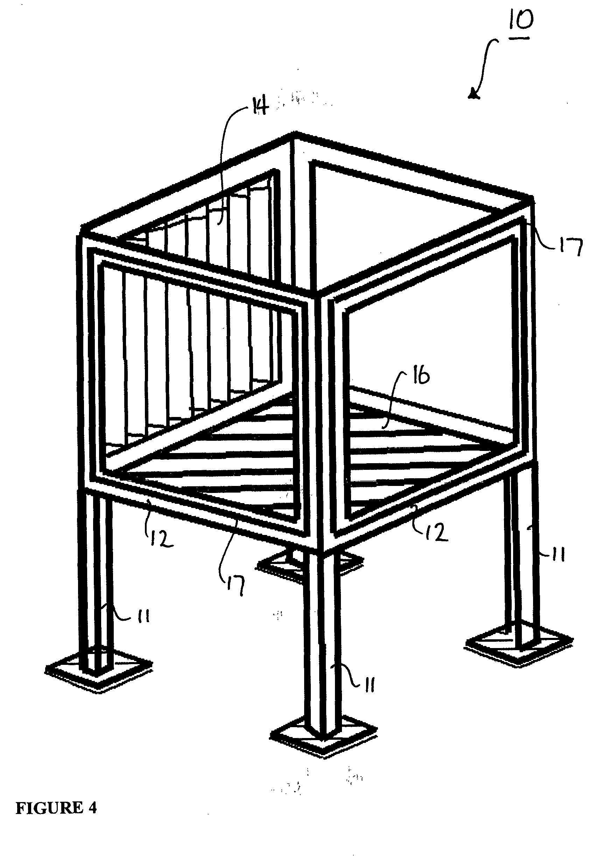

Figure 3 is a diagrammatic representation of air flowing between two immediately adjacent configurable flooring modules 10 embodying the present invention. The flooring modules 10 in Figure 3 are viewed from the plane of the floor or floor tile looking toward the baseplate 16. When two configurable flooring modules 10 are arranged side by side as shown in Figure 3, the contact between immediately adjacent external wall surfaces provides, an air-tight joint: one possible way of achieving this would be by providing silicon or rubber seals on the external surfaces of the wall frames 12 composing each side of the module, as shown in Figure 4, and possibly also by joining adjacent modules with rivets, bolts, clamps or any other suitable means for assembly, or merely by placement.

It can be seen that the shutters at the apertures of the immediately adjacent walls of each configurable flooring module 10 in Figure 3 are in an open state, so that fluid (in this example the fluid is air) can flow between the two flooring modules 10, and hence the apertures at the boundary between the modules are in fluid communication with one another. Seals 17 surrounding the aperture at the external face of each wall contact at the immediately adjacent walls to form an airtight seal to reduce fluid loss between modules. It can be appreciated from Figure 3 that, should either of the two apertures at the boundary between the modules 10 be configurable and have its configuration changed from open to closed, that the flow of fluid would be changed.

The closed shutters at the walls of the surfaces not immediately adjacent to the other module, the raised floor (not visible), and the baseplate, form a passage, duct, or plenum through which air (or another fluid) is conducted with minimal leakage. In this way, by remotely opening or closing shutters a user or automated control system can configure hermetic air ducts in a fast and convenient way, re-routing air and hence optimising the delivery of airflow from CRACs or some other source of air (such as a vent to the external environment) to the places where it is needed as the placement of heat sources within the enclosure in which the raised floor is installed changes. Re-routing the air is achieved by reconfiguring the configurable apertures simply by sending remote signals in response to which actuator units 15 open or close shutters 14. Disassembly of the raised floor is not required and hence a single operator can reconfigure the raised floor ducting and install/remove perforated tiles if necessary in a very short time, saving both time and workforce expenses. The plenums of two or more flooring modules in fluid communication with one another can be considered to be a duct.

Figure 4 illustrates a configurable flooring module 10 embodying the present invention. It can be seen that the external faces of the walls 12 visible in the Figure are provided with a seal 17 surrounding the aperture. The seals are configured so that when the flooring module is placed immediately adjacent to another flooring module having an aperture and seal on its external face such that the immediately adjacent apertures are in fluid communication with one another, the seals can be placed in contact with one another to form an airtight seal, or a seal which reduces the loss of fluid between the two apertures.

The apertures in the walls 12 are square-shaped in the particular embodiment depicted in Figures 1-4 but they may also have other forms such as circular, oval or polygonal. Of course, the shape of the seal 17 does not necessarily need to be the same as the aperture, although a better performance is achieved if the seal surrounds the aperture.

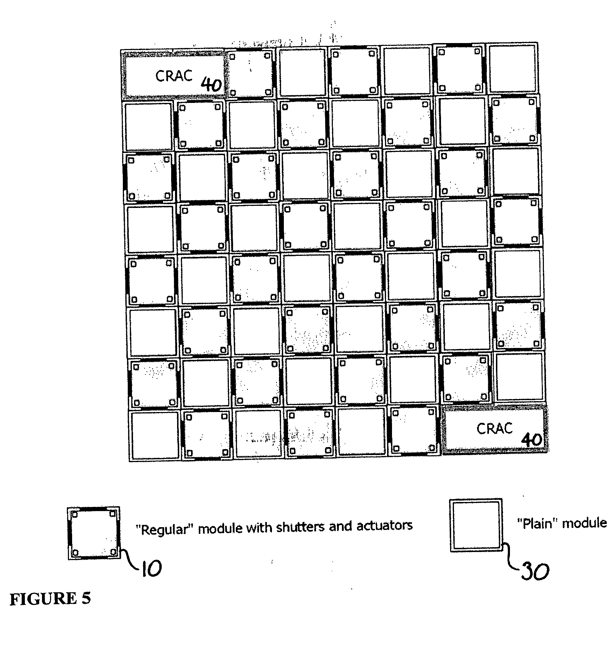

Figure 5 illustrates an exemplary arrangement of flooring modules in a raised floor. Not every module in a raised floor needs to be provided with configurable apertures. In fact, as few as one configurable aperture in fluid communication with a fluid source in a raised floor is sufficient to achieve technical benefits by the ability to remotely re-route fluid in a raised-floor controlled-fluid-flow system. In the exemplary raised floor embodiment depicted in Figure 5, "non-configurable" or "plain" flooring modules (not fitted with configurable apertures) are tessellated with "regular" modules (provided with configurable apertures) in a checkerboard fashion. Hence the capacity to configure any desired underfloor duct or geometry is achieved. As a further alternative, a raised floor embodiment built entirely with "regular" modules would have the advantage of 1 to 1 configurable aperture redundancy, so that if an actuator for a particular aperture becomes non-functional, as long as it is set to an open position, the ability to configure any desired underfloor duct geometry is preserved by operating the configurable aperture of the immediately adjacent configurable flooring module 10 sharing a boundary with the non-functional configurable aperture.

The non-configurable flooring modules 30 may be dimensioned in accordance with the configurable flooring modules 10 so that the arrangement of modules to provide a raised floor is simplified. However, it can be appreciated that raised floors embodying the present invention are not limited to such dimensions, and any flooring modules or other equipment maintaining fluid communication between configurable flooring modules 10 and sources of fluid can be used in raised floors embodying the present invention.

The raised floor illustrated in Figure 5 also includes two CRAC units 40 as sources of fluid, in this case cold air. An aperture of at least one configurable flooring module 10 or non-configurable flooring module 30 is arranged to receive cold air from each of the CRAC units 40.

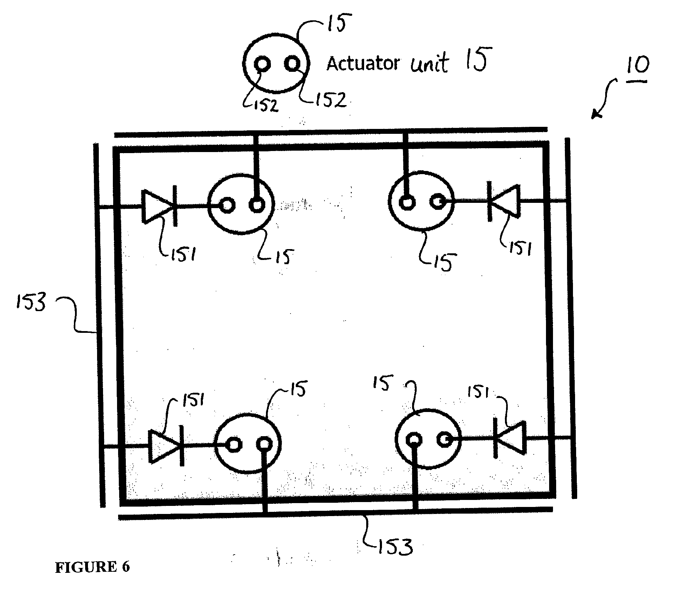

A wiring diagram for the actuators is shown schematically in Figure 6 for a particular embodiment of this invention. The embodiment illustrated in Figure 6 includes four walls with configurable apertures, each having its own actuator unit 15. Each actuator unit has two signal receiving sensors 152 configured to sense when a remote signal activating the actuator unit 15 has been received, a diode 151, and connections to signal line sections 153. It may be that each actuator unit 15 is configured so that it only changes the state of a configurable aperture between an open state and a closed state when a particular (for example, hi) signal is received simultaneously at both of its signal receiving sensors 152. Alternatively, there may be a predetermined time window within which a particular signal must be received at either signal receiving sensor 152 of the actuator in order to trigger a change in the state of the configurable aperture. The two signal receiving sensors 152 of any particular actuator unit 15 are each connected to separate signal line sections 153 which are isolated from one another, so that a pair of signals is required to trigger the actuator unit 15 to change the state of the configurable aperture. This is particularly advantageous in a grid arrangement of flooring modules, because it enables signal line sections to be arranged in a grid format and hence each actuator unit 15 is addressable by sending appropriately timed signals on a particular pair of signal lines.

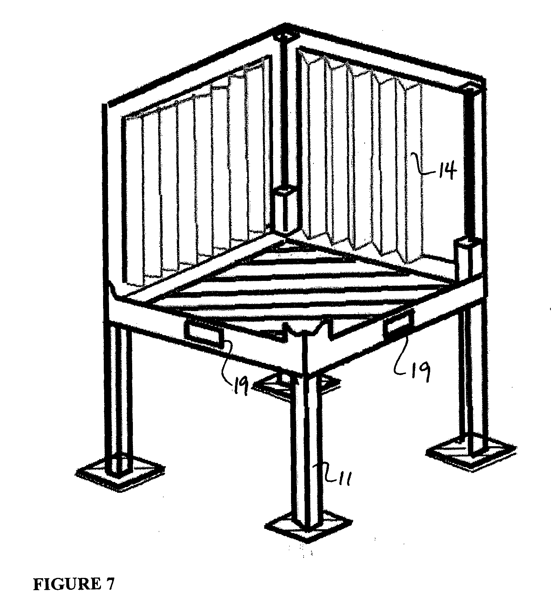

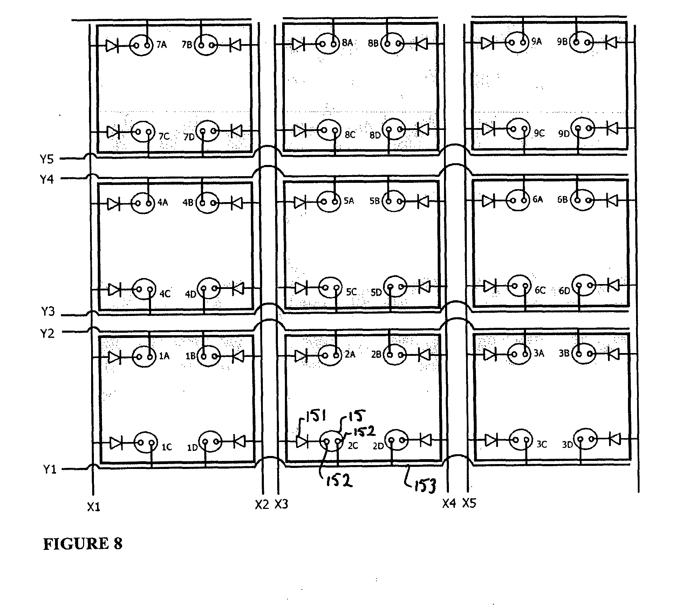

Signal line sections 153 which are required to be connected to neighbouring or immediately adjacent modules can have their ends made accessible to adjacent modules via a plug and socket arrangement or some other form of connecting element. For example, connecting elements 19 such as plugs and sockets are integrated in the structure of the module as shown in Figure 7. In an exemplary embodiment, a connecting element 19 is provided on each external wall surface of a flooring module 10. When the modules are joined together to form a raised floor structure the wirings in each module are automatically connected together forming the grid-like arrangement shown in Figure 8. Alternatively, it may be that some additional connecting apparatus is required, for example a male to female adapter, in order to connect signal line sections 153 of adjacent modules 10.

Figure 8 shows a wiring layout of a plurality of configurable flooring modules 10 arranged in a grid. Each flooring module in Figure 8 has four configurable apertures each having its own actuator unit 1A-D, 2A-D, ..., 9A-D although it can be appreciated that the same overall layout of signal lines could be used with fewer configurable apertures. In fact, it would be possible to include non-configurable flooring modules in the gird, as long as they include signal line sections to connect signal lines of immediately adjacent modules in the same grid row or column. The signal line sections of immediately adjacent flooring modules in a particular row or column connect, for example via a connecting element 19, to form a signal line Y1-5, X1-5. In an exemplary embodiment, co-directional signal line sections of one configurable flooring module connect to the immediately adjacent flooring module via a single connecting element 19. For example, as signal lines Y1' and Y2 cross boundaries between flooring modules, they can be joined by a single connecting element (although they should be isolated from one another to prevent signal interference). With this wiring layout/cabling scheme individual actuator units are activated by applying voltages (as signals) to the appropriate signal lines (conductors) along the edges of the raised floor: For instance, to activate actuator unit 8C in Figure 8 a voltage must be applied to signal lines X3 and Y5.

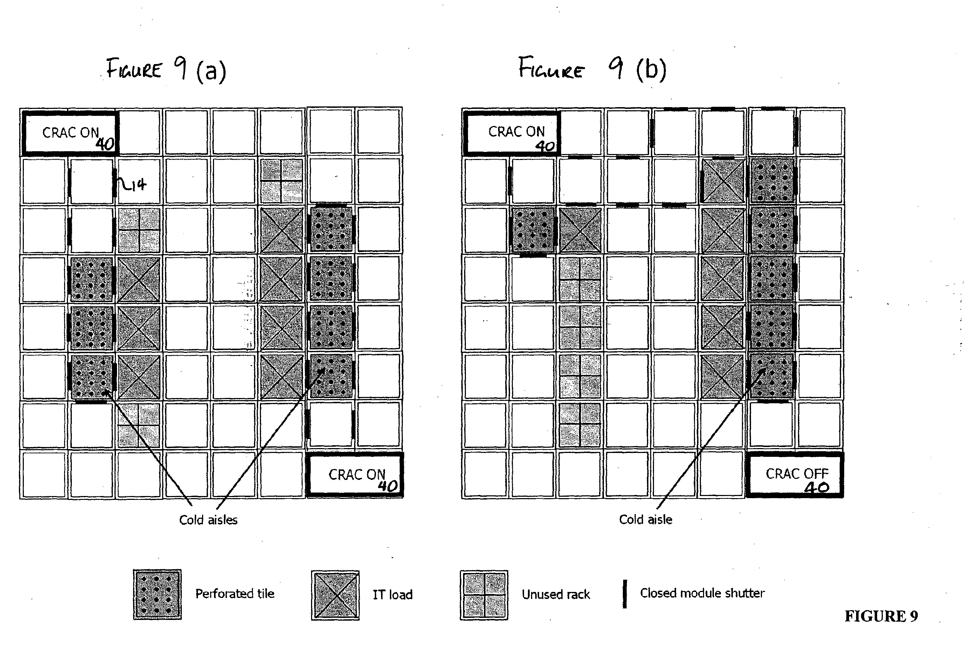

As an application example of the proposed invention, we consider a data centre hall as an example of an enclosure, with two rows of racks on a raised floor embodying the present invention, and two CRAC units 40 feeding cooled air into groups of configurable flooring modules 10 arranged to form a grid, and configured to form ducts, as depicted in Figures 9a and 9b. In Figure 9a, the configurable flooring modules 10 have been used to configure two cold aisles (ducts formed by immediately adjacent configurable flooring modules 10 having perforated tiles to feed cooled air from the CRAC unit into the enclosure in which the raised floor is installed), each fed from a duct conducting cold air supplied by a CRAC unit to the IT loads on the racks. Each grid square of the grids depicted in Figures 9a and 9b corresponds to a configurable flooring module 10, though it is of course possible that many of the flooring modules could be non-configurable. The location of closed configurable apertures is illustrated by block dashes, and the locations of perforated floor tiles through which air can be fed from the plenum of a configurable flooring module 10 into the enclosure is also shown. In Figure 9b the placement of the IT loads has changed, and the underfloor ducting has been reconfigured so that the required airflow is supplied by a single CRAC unit, allowing the remaining one to be turned off.

As shown by examining the differences between Figures 9a and 9b, the use of configurable flooring modules 10 embodying the invention allows not only optimum airflow distribution to be achieved: energy savings can also be obtained by either turning off unnecessary CRAC units and by regulating fan speed in active ones to deliver just the necessary airflow to the IT equipment. Additionally, air leakage as well as energy losses associated to underfloor obstructions are minimised. The shutters in a module can be partially closed in order to achieve a desired pressure distribution within a duct. Additional energy savings by optimising the locations to which cooled air is delivered can be achieved by changing the locations of perforated floor tiles.

In an exemplary embodiment, the actuator units in the configurable flooring modules (and possibly the CRAC units) are controlled by a predictive control system based on a 3-D CFD (computation fluid dynamics) model of the data centre. The following information may be supplied to the algorithm that controls the system, either manually or by a data centre management system: data centre layout (including room geometry, disposition of racks, CRACs and perforated tiles); thermal load (power consumption per rack, calculated from number of active servers/IT loads or supplied by a data centre management system); CRAC temperature and airflow settings; temperature of other fluid sources (for example, external air); initial underfloor duct geometry (configuration of configurable flooring modules); server temperatures (ideally supplied by the data centre management system). Of course, whilst this example is tailored to data centres, it is possible for a heat flow simulation of any system, fed with appropriate information, to be used in place of the 3-D CFD model simulation.

The output of the 3-D CFD simulation (as an example of a heat flow simulation) is the airflow rate that must be supplied to the ducts in order to remove the heat generated by the IT equipment. With that information a controller, for example using an algorithm, calculates: the number of CRACs that are required to provide this airflow, and if the CRACs are fitted with variable speed fans these can be adjusted to provide just the required amount of airflow; and the geometry of the ducting to achieve optimum cooling for the current IT load distribution and for the total supplied airflow, that is to say, the configuration of configurable apertures required to achieve the required ducting geometry.

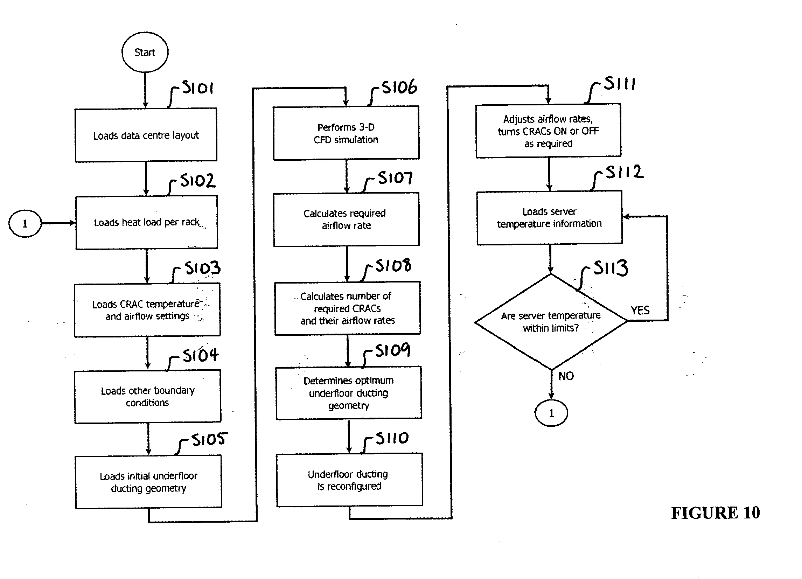

Figure 10 illustrates a flow of control in a method of operating a configurable flooring module or raised floor embodying the present invention. At step S101 the data centre layout is loaded into a heat flow simulator. The data centre is used an example of an enclosure having controlled fluid flow, but invention embodiments can be used in any facility requiring controlled airflow and where energy consumption is a constraint, such as hospitals, recording studios, factories, laboratories, etc.

At step S102 operating properties of the equipment within the enclosure are loaded into the heat flow simulator, specifically thermal information is loaded as an operating property, for example, heat load. In the data centre example, the heat load per rack is loaded.

At step S103 the operating conditions of fluid sources, such as air conditioning units, CRAC units, or external airflow, and the airflow settings of those fluid sources are loaded into the heat flow simulator. At step S104 additional boundary conditions, for example absolute and/or relative humidity, are loaded into the heat flow simulator.

At step S105 the initial geometry of the underfloor ducting is loaded into the heat flow simulator.

At step S106 the heat flow simulation is performed, wherein a 3-D CFD simulation is used in the illustration as an example of a heat flow simulation that may be used in a data centre-implemented invention embodiment. The output of the heat flow simulation is produced at step S107, the output being the fluid flow (such as airflow) required in the enclosure to remove the heat generated by the equipment/heat sources based on the information loaded to the simulator.

At step S108 a controller (for example, a user or automated control program) is used to calculate which fluid sources are required to achieve the required fluid flow. For example it may be that the number of CRAC units and the airflow rate required to be generated by each CRAC unit is calculated. The calculations may also include specification of which CRAC units or fluid sources are to be used.

At step S109 the controller determines the optimum underfloor ducting geometry to ensure that the fluid is fed into the enclosure at locations where the cooling effect will be optimised. The underfloor ducting geometry corresponds to a configuration of configurable apertures, and at step S110 the remote signals to achieve the optimum underfloor ducting geometry are sent. It is also possible that steps S109 and S110 include specifying where perforated tiles are to be used, and the provision of perforated tiles in the specified locations.

At step S111 the required adjustments to the operation of the fluid sources such as CRAC units are made.

Steps S112 and S113 constitute a checking procedure which may be carried out periodically, or may be triggered by events such as high temperature being sensed within the enclosure. At step S112 temperature information from within the enclosure or from within equipment in the enclosure, such as servers in a data centre, is loaded by the controller. If the temperature information indicates that the temperatures of the equipment or enclosure (depending on the implementation) are within predetermined limits (which may be a simple maximum temperature threshold) then the check is simply repeated. If the temperature information indicates that the temperatures are not within the predetermined limits, then the flow returns to step S102 and a reconfiguration is performed (by performing steps S102 to S111).

In any of the above aspects, the various features may be implemented in hardware, or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

## Claims

1. A configurable flooring module (10) for use in a raised-floor controlled-fluid-flow system, the flooring module comprising:
a raised floor support surface (18) and an elevation structure configured to hold the raised floor support surface in an elevated position;
a first wall (12) of the elevation structure having a first wall aperture, and a second wall (12) of the elevation structure having a second wall aperture;
the first wall providing a side of a plenum and the second wall providing another side of a plenum, which plenum, when in use, provides a fluid connection between the first wall aperture and the second wall aperture; and
an actuator (15), a shutter (14), and a remote signal receiver (152); wherein
at least the first wall aperture is configured to be opened and closed by the actuator moving the shutter in response to a remote signal received by the remote signal receiver.

2. A configurable flooring module (10) according to claim 1, wherein:
when a raised floor is fitted to the raised floor support surface (18), the raised floor provides another wall (12) of the plenum.

3. A configurable flooring module (10) according to claim 1 or 2, further comprising:
a perforated floor tile fitted to the raised floor support surface (18) as a raised floor.

4. A configurable flooring module (10) according to any of claim 2 or 3, further comprising:
a baseplate (16) providing a side of the plenum opposed to the side provided by the raised floor when the raised floor is fitted.

5. A configurable flooring module (10) according to claim 4, wherein the elevation structure further comprises one or more stands (11) configured to support the raised floor above a fixed floor such that the baseplate (16) is also raised above the fixed floor.

6. A configurable flooring module (10) according to claim 5, wherein
the baseplate (16) is removable.

7. A configurable flooring module (10) according to any of claims 1 to 6, the flooring module further comprising:
a third wall (12) of the elevation structure having a third wall aperture, the third wall providing a side of the plenum; wherein
at least the first wall aperture and second wall aperture are each configured to be opened and closed by the actuator (15) moving the shutter (14) in response to a remote signal received by the remote signal receiver (152).

8. A configurable flooring module (10) according to claim 7, the flooring module further comprising:
a fourth wall (12) of the elevation structure having a fourth aperture, the fourth wall providing a side of the plenum; wherein
at least the first wall aperture, second wall aperture, and third wall aperture are each configured to be opened and closed by the actuator (15) moving the shutter (14) in response to a remote signal received by the remote signal receiver (152).

9. A configurable flooring module (10) according to any of claims 1 to 8, wherein
the or each wall is in the form of a wall frame surrounding its respective aperture and forms a complete wall when the aperture is closed.

10. A configurable flooring module (10) according to any of claims 1 to 9, wherein
the or each aperture comprises a plurality of sub-apertures, and the aperture is closed when each of its plurality of sub-apertures is closed.

11. A modular raised floor for use in a raised-floor controlled-fluid-flow system, the modular raised floor comprising a plurality of flooring modules, of which at least one flooring module is a configurable flooring module (10) in accordance with any of claims 1 to 10, and any remaining flooring modules are non-configurable flooring modules, each non-configurable flooring module comprising:
a raised floor support surface and an elevation structure configured to hold the raised floor support surface in a raised position; and
walls of the elevation structure having apertures and providing sides of a plenum, which plenum, when in use, provides fluid connections between the apertures.

12. A modular raised floor according to claim 11, wherein there is more than one configurable flooring module (10), and
the modular raised floor is configurable such that the first aperture of a first configurable flooring module and the first aperture of a second configurable flooring module are in fluid communication with one another and with a source of fluid.

13. A modular raised floor according to claim 11, wherein
the plurality of flooring modules are configured to be arranged in a grid of horizontal rows and columns.

14. A modular raised floor according to claim 13, wherein
the remote signal receiver (152) of each configurable flooring module (10) comprises, for each aperture that is configured to be opened and closed in response to a remote signal received by the remote signal receiver (152), first and second signal receivers respectively connected to first and second signal line sections (153);
wherein, when the plurality of flooring modules are arranged in a grid:
the first signal line section is connectable to signal line sections of adjacent flooring modules to form a signal line running along a grid row; and
the second signal line section is connectable to signal line sections of adjacent flooring modules to form a signal line running along a grid column.

15. A method of use of a modular raised floor according to any of claims 11 to 14, comprising:
conducting a heat flow simulation of a model of a room in which the raised floor is installed;
determining, based on the heat flow simulation, from among the apertures that are configured to be opened and closed, a desired configuration of apertures that should be opened and apertures that should be closed; and
sending remote signals to the remote signal receiver of the configurable flooring modules to realise the desired configuration.

## Patentansprüche

1. Konfigurierbares Fußbodenmodul (10) zur Verwendung in einem gesteuerten Fluiddurchflusssystem für Zwischenböden, wobei das Fußbodenmodul umfasst:
eine Zwischenbodenträgeroberfläche (18) und eine Hebestruktur, die konfiguriert ist, um die Zwischenbodenträgeroberfläche in einer angehobenen Position zu halten;
eine erste Wand (12) der Hebestruktur mit einer ersten Wandöffnung und eine zweite Wand (12) der Hebestruktur mit einer zweiten Wandöffnung;
wobei die erste Wand eine Seite einer Kammer bereitstellt und die zweite Wand eine andere Seite einer Kammer bereitstellt, wobei die Kammer, wenn sie im Gebrauch ist, eine Fluidverbindung zwischen der ersten Wandöffnung und der zweiten Wandöffnung bereitstellt;
einen Stellantrieb (15), ein Verschlusselement (14) und einen entfernten Signalempfänger (152); wobei mindestens die erste Wandöffnung konfiguriert ist, um durch den Stellantrieb, der das Verschlusselement als Reaktion auf ein entferntes Signal, das durch den entfernten Signalempfänger empfangen wird, bewegt, geöffnet und geschlossen zu werden.

2. Konfigurierbares Fußbodenmodul (10) nach Anspruch 1, wobei:
dann, wenn ein Zwischenboden an der Zwischenbodenträgeroberfläche (18) eingebaut wird, der Zwischenboden eine andere Wand (12) der Kammer bereitstellt.

3. Konfigurierbares Fußbodenmodul (10) nach Anspruch 1 oder 2, das ferner umfasst:
eine perforierte Bodenfliese, die an der Zwischenbodenträgeroberfläche (18) als ein Zwischenboden eingebaut ist.

4. Konfigurierbares Fußbodenmodul (10) nach Anspruch 2 oder 3, das ferner umfasst:
eine Grundplatte (16), die eine Seite der Kammer gegenüber der Seite bereitstellt, die von dem Zwischenboden bereitgestellt wird, wenn der Zwischenboden eingebaut wird.

5. Konfigurierbares Fußbodenmodul (10) nach Anspruch 4, wobei die Hebestruktur ferner ein oder mehrere Standbeine (11) umfasst, die konfiguriert sind, um die Hebestruktur über einem festen Boden derart zu tragen, dass die Grundplatte (16) ebenfalls über den festen Boden angehoben wird.

6. Konfigurierbares Fußbodenmodul (10) nach Anspruch 5, wobei die Grundplatte (16) entfernbar ist.

7. Konfigurierbares Fußbodenmodul (10) nach einem der Ansprüche 1 bis 6, wobei das Fußbodenmodul ferner umfasst:
eine dritte Wand (12) der Hebestruktur mit einer dritten Wandöffnung, wobei die dritte Wand eine Seite der Kammer bereitstellt; wobei
mindestens die erste Wandöffnung und die zweite Wandöffnung jeweils konfiguriert sind, um durch den Stellantrieb (15), der das Verschlusselement (14) als Reaktion auf ein entferntes Signal, das durch den entfernten Signalempfänger (152) empfangen wird, bewegt, geöffnet und geschlossen zu werden.

8. Konfigurierbares Fußbodenmodul (10) nach Anspruch 7, wobei das Fußbodenmodul ferner umfasst:
eine vierte Wand (12) der Hebestruktur mit einer vierten Wandöffnung, wobei die vierte Wand eine Seite der Kammer bereitstellt; wobei
mindestens die erste Wandöffnung, die zweite Wandöffnung und die dritte Wandöffnung jeweils konfiguriert sind, um durch den Stellantrieb (15), der das Verschlusselement (14) als Reaktion auf ein entferntes Signal, das durch den entfernten Signalempfänger (152) empfangen wird, bewegt, geöffnet und geschlossen zu werden.

9. Konfigurierbares Fußbodenmodul (10) nach einem der Ansprüche 1 bis 8, wobei die oder jede Wand in der Form eines Wandgerüsts ist, das seine jeweilige Öffnung umgibt und eine vollständige Wand bildet, wenn die Öffnung geschlossen ist.

10. Konfigurierbares Fußbodenmodul (10) nach einem der Ansprüche 1 bis 9, wobei die oder jede Öffnung mehrere Unteröffnungen umfasst und wobei die Öffnung geschlossen ist, wenn jede der mehreren Unteröffnungen geschlossen ist.

11. Modularer Zwischenboden zur Verwendung in einem gesteuerten Fluiddurchflusssystem für Zwischenböden, wobei der modulare Zwischenboden mehrere Fußbodenmodule umfasst, von denen mindestens ein Fußbodenmodul ein konfigurierbares Fußbodenmodul (10) nach einem der Ansprüche 1 bis 10 ist, und alle übrigen verbleibenden Fußbodenmodule nicht konfigurierbare Fußbodenmodule sind, wobei jedes nicht konfigurierbare Fußbodenmodul umfasst:
eine Zwischenbodenträgeroberfläche und eine Hebestruktur, die konfiguriert ist, um die Zwischenbodenträgeroberfläche in einer angehobenen Position zu halten; und
Wände der Hebestruktur, die Öffnungen aufweisen und Seiten einer Kammer bereitstellen, wobei die Kammer, wenn sie in Gebrauch ist, Fluidverbindungen zwischen den Öffnungen bereitstellt.

12. Modularer Zwischenboden nach Anspruch 11, wobei es mehr als ein konfigurierbares Fußbodenmodul (10) gibt, und
wobei der modulare Zwischenboden derart konfigurierbar ist, dass die erste Öffnung eines ersten konfigurierbaren Fußbodenmoduls und die erste Öffnung eines zweiten konfigurierbaren Fußbodenmoduls in einer Fluidkommunikation miteinander und mit einer Fluidquelle stehen.

13. Modularer Zwischenboden nach Anspruch 11, wobei
die mehreren Fußbodenmodule konfiguriert sind, um in einem Gitternetz von horizontalen Zeilen und Reihen angeordnet zu werden.

14. Modularer Zwischenboden nach Anspruch 13, wobei
der entfernte Signalempfänger (152) jedes konfigurierbaren Fußbodenmoduls (10) für jede Öffnung, die konfiguriert ist, um als Reaktion auf ein entferntes Signal, das durch den entfernten Signalempfänger (152) empfangen wird, geöffnet und geschlossen zu werden, einen ersten und einen zweiten Signalempfänger umfasst, der mit dem ersten bzw. mit dem zweiten Signalleitungsabschnitt (153) verbunden ist;
wobei dann, wenn die mehreren Fußbodenmodule in einem Gitternetz angeordnet sind:
der erste Signalleitungsabschnitt mit Signalleitungsabschnitten von benachbarten Fußbodenmodulen verbindbar ist, um eine Signalleitung zu bilden, die entlang einer Gitternetzzeile verläuft; und
der zweite Signalleitungsabschnitt mit Signalleitungsabschnitten von benachbarten Fußbodenmodulen verbindbar ist, um eine Signalleitung zu bilden, die entlang einer Gitternetzreihe verläuft.

15. Verfahren zur Verwendung eines modularen Zwischenbodens nach einem der Ansprüche 11 bis 14, das umfasst:
Leiten einer Wärmeflusssimulation eines Modells eines Raums, in dem der Zwischenboden installiert ist;
von den Öffnungen, die konfiguriert sind, um geöffnet und geschlossen zu werden, auf der Grundlage der Wärmeflusssimulation Bestimmen einer gewünschten Konfiguration von Öffnungen, die geöffnet sein sollen, und von Öffnungen, die geschlossen sein sollen; und
Senden von entfernten Signalen an den entfernten Signalempfänger der konfigurierbaren Fußbodenmodule, um die gewünschte Konfiguration zu realisieren.

## Revendications

1. Module de revêtement de plancher configurable (10) destiné à être utilisé dans un système de débit contrôlé des fluides de plancher surélevé, le module de revêtement de plancher comprenant :
une surface de support de plancher surélevé (18) et une structure d'élévation configurée pour maintenir la surface de support de plancher surélevé dans une position élevée ;
une première paroi (12) de la structure d'élévation ayant une première ouverture de paroi, et une deuxième paroi (12) de la structure d'élévation ayant une deuxième ouverture de paroi ;
la première paroi fournissant un côté d'un plénum et la deuxième paroi fournissant un autre côté d'un plénum, lequel plénum, lorsqu'il est utilisé, fournit un raccordement de fluide entre la première ouverture de paroi et la deuxième ouverture de paroi ; et
un actionneur (15), un obturateur (14) et un récepteur de signal à distance (152) ; dans lequel
au moins la première ouverture de paroi est configurée pour être ouverte et fermée par l'actionneur qui déplace l'obturateur en réponse à un signal à distance reçu par le récepteur de signal à distance.

2. Module de revêtement de plancher configurable (10) selon la revendication 1, dans lequel :
lorsqu'un plancher surélevé est monté sur la surface de support de plancher surélevé (18), le plancher surélevé fournit une autre paroi (12) du plénum.

3. Module de revêtement de plancher configurable (10) selon la revendication 1 ou 2, comprenant en outre :
un carreau perforé installé sur la surface de support de plancher surélevé (18) en tant que plancher surélevé.

4. Module de revêtement de plancher configurable (10) selon l'une quelconque des revendications 2 ou 3, comprenant en outre :
une plaque de base (16) fournissant un côté du plénum opposé au côté fourni par le plancher surélevé lorsque le plancher surélevé est monté.

5. Module de revêtement de plancher configurable (10) selon la revendication 4, dans lequel la structure d'élévation comprend un ou plusieurs supports (11) configurés pour supporter le plancher surélevé au-dessus d'un plancher fixe de sorte que la plaque de base (16) est également surélevée au-dessus du plancher fixe.

6. Module de revêtement de plancher configurable (10) selon la revendication 5, dans lequel
la plaque de base (16) est amovible.

7. Module de revêtement de plancher configurable (10) selon l'une quelconque des revendications 1 à 6, le module de revêtement de plancher comprenant en outre :
une troisième paroi (12) de la structure d'élévation ayant une troisième ouverture de paroi, la troisième paroi fournissant un côté du plénum ; dans lequel
au moins la première ouverture de paroi et la deuxième ouverture de paroi sont chacune configurées pour être ouvertes et fermées par l'actionneur (15) qui déplace l'obturateur (14) en réponse à un signal à distance reçu par le récepteur de signal à distance (152).

8. Module de revêtement de plancher configurable (10) selon la revendication 7, le module de revêtement de plancher comprenant en outre :
une quatrième paroi (12) de la structure d'élévation ayant une quatrième ouverture, la quatrième paroi fournissant un côté du plénum ; dans lequel
au moins la première ouverture de paroi, la deuxième ouverture de paroi et la troisième ouverture de paroi sont chacune configurées pour être ouvertes et fermées par l'actionneur (15) qui déplace l'obturateur (14) en réponse à un signal à distance reçu par le récepteur de signal à distance (152).

9. Module de revêtement de plancher configurable (10) selon l'une quelconque des revendications 1 à 8, dans lequel
la ou chaque paroi se présente sous la forme d'un bâti de paroi entourant son ouverture respective et forme une paroi complète lorsque l'ouverture est fermée.

10. Module de revêtement de plancher configurable (10) selon l'une quelconque des revendications 1 à 9, dans lequel
la ou chaque ouverture comprend une pluralité de sous-ouvertures et l'ouverture est fermée lorsque chacune de sa pluralité de sous-ouvertures est fermée.

11. Plancher surélevé modulaire destiné à être utilisé dans un système de débit contrôlé des fluides de plancher surélevé, le plancher surélevé modulaire comprenant une pluralité de modules de revêtement de plancher, dont au moins un module de revêtement de plancher est un module de revêtement de plancher configurable (10) selon l'une quelconque des revendications 1 à 10 et tous les modules de revêtement de plancher restants sont des modules de revêtement de plancher non configurables, chaque module de revêtement de plancher non configurable comprenant :
une surface de support de plancher surélevé et une structure d'élévation configurée pour maintenir la surface de support de plancher surélevé dans une position surélevée ; et
des parois de la structure d'élévation ayant des ouvertures et fournissant des côtés d'un plénum, lequel plénum, lorsqu'il est utilisé, fournit des raccordements de fluide entre les ouvertures.

12. Plancher surélevé modulaire selon la revendication 11, dans lequel il y a plus d'un module de revêtement de plancher configurable (10), et
le plancher surélevé modulaire est configurable de sorte que la première ouverture d'un premier module de revêtement de plancher configurable et la première ouverture d'un second module de revêtement de plancher configurable sont en communication de fluide entre eux et avec une source de fluide.

13. Plancher surélevé modulaire selon la revendication 11, dans lequel
la pluralité de modules de revêtement de plancher sont configurés pour être agencés dans une grille de rangées horizontales et de colonnes.

14. Plancher surélevé modulaire selon la revendication 13, dans lequel
le récepteur de signal à distance (152) de chaque module de revêtement de plancher configurable (10) comprend, pour chaque ouverture qui est configurée pour être ouverte et fermée en réponse à un signal à distance reçu par le récepteur de signal à distance (152), des premier et second récepteurs de signal respectivement raccordés aux première et seconde sections de ligne de signal (153) ;
dans lequel, lorsque la pluralité de modules de revêtement de plancher sont agencés dans une grille :
la première section de ligne de signal peut être raccordée aux sections de ligne de signal des modules de revêtement de plancher adjacents afin de former une ligne de signal s'étendant le long d'une rangée de grille ; et
la seconde section de ligne de signal peut être raccordée aux sections de ligne de signal des modules de revêtement de plancher adjacents afin de former une ligne de signal s'étendant le long d'une colonne de grille.

15. Procédé pour utiliser un plancher surélevé modulaire selon l'une quelconque des revendications 11 à 14, comprenant les étapes consistant à :
réaliser une simulation d'écoulement de chaleur d'un modèle d'une pièce dans laquelle le plancher surélevé est installé ;
déterminer, en fonction de la simulation d'écoulement de chaleur, parmi les ouvertures qui sont configurées pour être ouvertes et fermées, une configuration souhaitée des ouvertures qui doivent être ouvertes et des ouvertures qui doivent être fermées ; et
envoyer des signaux à distance au récepteur de signal à distance des modules de revêtement de plancher configurables afin de réaliser la configuration souhaitée.
